# EUROPEAN PATENT SPECIFICATION

(11) **EP 3 757 526 B1**
(45) Date of publication and mention of the grant of the patent: **13.03.2024**
(21) Application number: 19183250.0
(22) Date of filing: 28.06.2019
(51) Int. Cl.: G01D 21/00, H04B 5/00

(54) **RESONATOR ARRAY SENSOR ARRANGEMENT**
SENSORANORDNUNG EINES RESONATORARRAYS
AGENCEMENT DE CAPTEUR DE RÉSEAU DE RÉSONATEUR

(43) Date of publication of application: 30.12.2020
(73) Proprietor: Hitachi Energy Ltd, 8050 Zürich (CH)
(72) Inventor: RUSSBERG, Gunnar, 724 62 Västerås (SE); SALINAS, Ener, 722 10 Västerås (SE); PRIETO COLMENERO, Lorenzo Luis, 14012 Cordoba (ES)
(74) Representative: Valea AB

(56) References cited:
- US-A- 4 025 912
- US-A1- 2010 177 801
- US-A1- 2017 140 870
- US-A1- 2017 167 250
- CHRISTOPHER J. STEVENS: "A magneto-inductive wave wireless power transfer device", WIRELESS POWER TRANSFER, vol. 2, no. 01, 1 March 2015 (2015-03-01), pages 51-59, XP055510590, DOI: 10.1017/wpt.2015.3

## Description

### TECHNICAL FIELD

The present disclosure relates to a sensor arrangement for measuring a property of an environment in an electrical device.

### BACKGROUND

Power transformers and other high-voltage (HV) devices typically involve components (core, conductors, paper insulation, structural elements, sensors, etc.) exposed to extreme conditions e.g. in an insulation-oil filled tank enclosure. This implies high electric field strengths due to voltage differences of tens or hundreds of kilovolts, elevated temperatures exceeding 100-130°C due to losses in windings and magnetic core, structural forces and vibrations, support pressures of the order hundred MPa, magnetic fields of the order 1.5-2 T, etc. For the monitoring and control of a power transformer, strategically positioned sensors and means for their operation (powering and communication) are essential components. Sensor solutions can be wired (e.g., optical wire) or wireless (e.g., WiFi or Radio Frequency, RF & RFID). Conventional conducting wire sensor solutions are automatically ruled out since they will generally not comply with the HV insulation demands. Transfer of power and signal via fibre optic is possible, but a problem is that optical fibres are sensitive to mechanical stress.

Sensors and their means for operation should not reduce the transformer internal insulation strength or increase the risk for electrical breakdown. They should preferably fit into existing transformer designs with negligible demands for design alterations or extra space.

The harsh environment in which the sensing system has to work puts high demands on robustness and endurance, without becoming complex, bulky and/or expensive as many existing wireless (sensing and communication) solutions tend to be.

Sensor devices need access to an electric power supply during their entire life of operation. Traditional long life batteries are bulky and expensive. Passive (RF, RFID) wireless technologies, however, do not require batteries. RFID systems may feed both power to and signal from a sensing unit but are typically very short-range (a few dm). Required distances to bridge inside the transformer may be up to several meters, with associated accumulated potential differences of up to several hundred kilovolts.

Wireless power transfer from low voltage to high voltage can be achieved by means of resonator (inductance-capacitance, LC) coils to power e.g. sensors in a HV environments.

US 2017/140870 discloses a HV insulator with embedded resonator coils. The resonator coils form a series of relay resonators that can be used for wireless power transfer and can provide the simultaneous functions of voltage insulation and wireless power transfer in a high-voltage environment such as that encountered in high-voltage power transmission line systems.

### SUMMARY

It is an objective of the present invention to provide an improved sensor arrangement for measuring a property of an environment in an electrical device, especially a HV environment.

According to an aspect of the present invention, there is provided a sensor arrangement defined in claim 1.

According to another aspect of the present invention, there is provided a method of detecting a measured property in an electrical environment defined in claim 12.

According to another aspect of the present invention, there is provided a computer program defined in claim 13.

By the resonator array being arranged to both wirelessly transfer power to the sensor and to wirelessly transfer sensor signals to the detector, there is no need for a separate signal transfer arrangement such as via a Wireless Local Area Network (WLAN).

It is to be noted that any feature of any of the aspects may be applied to any other aspect, wherever appropriate. Likewise, any advantage of any of the aspects may apply to any of the other aspects. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second" etc. for different features/components of the present disclosure are only intended to distinguish the features/components from other similar features/components and not to impart any order or hierarchy to the features/components.

### BRIEF DESCRIPTION OF THE DRAWINGS

Embodiments will be described, by way of example, with reference to the accompanying drawings, in which:
Fig 1 is a schematic illustration of a sensor arrangement comprising a resonator array comprising a one-dimensional (1D) array of co-axial LC circuits, in accordance with an embodiment of the present invention.
Fig 2 is a schematic illustration of a sensor arrangement comprising a resonator array comprising a one-dimensional (1D) array of co-planar LC circuits, in accordance with an embodiment of the present invention.
Fig 3 is a schematic circuit diagram of a planar LC circuit printed on a film, in accordance with an embodiment of the present invention.
Fig 4 is a schematic block diagram of a sensor arrangement, in accordance with an embodiment of the present invention.
Fig 5 is a schematic block diagram of an electrical device comprising a sensor arrangement, in accordance with an embodiment of the present invention.
Fig 6 is a schematic block diagram of a controller of a sensor arrangement, in accordance with an embodiment of the present invention.
Fig 7 is a schematic flow chart of an embodiment of a method of the present invention.

### DETAILED DESCRIPTION

Embodiments will now be described more fully hereinafter with reference to the accompanying drawings, in which certain embodiments are shown. However, other embodiments in many different forms are possible within the scope of the present disclosure. Rather, the following embodiments are provided by way of example so that this disclosure will be thorough and complete, and will fully convey the scope of the disclosure to those skilled in the art. Like numbers refer to like elements throughout the description.

Embodiments of the invention aims at monitoring properties such as temperature and pressure in the harsh environment of high voltage devices such as power transformers without disturbing insulation properties and performance. However, embodiments of the invention may also be used for Low-Voltage (LV) or Medium-Voltage (MV) devices and environments thereof. Such monitoring requires transmitting power and signal relatively long distances, possibly across hundreds of kV electric potential. The sensor arrangement of the present invention may be regarded as a wireless monitoring system e.g. including i) at least one passive sensor unit in form of an LC-resonator with a natural frequency f depending sensitively on the property to be measured, ii) at least one array (one-, two- or three-dimensional, array) of LC-resonators with a fixed natural frequency fo arranged with finite separation, and/or iii) power supplying and signal detection units (which may or may not be integrated with each other), e.g., an impedance analyser, inductively coupled to the sensor via the resonator array. Embodiments of the invention may provide robust and low-cost wireless transfer of power and sensor signals over several meters of distance without need for embedded energy storage or power harvesting in the electrical device.

Sensors and their means for operation should preferably not reduce the internal insulation strength of the electrical device, e.g. a transformer, or in any way increase the risk for electrical breakdown. They should preferably fit into existing device designs with negligible demands for design alterations or extra space.

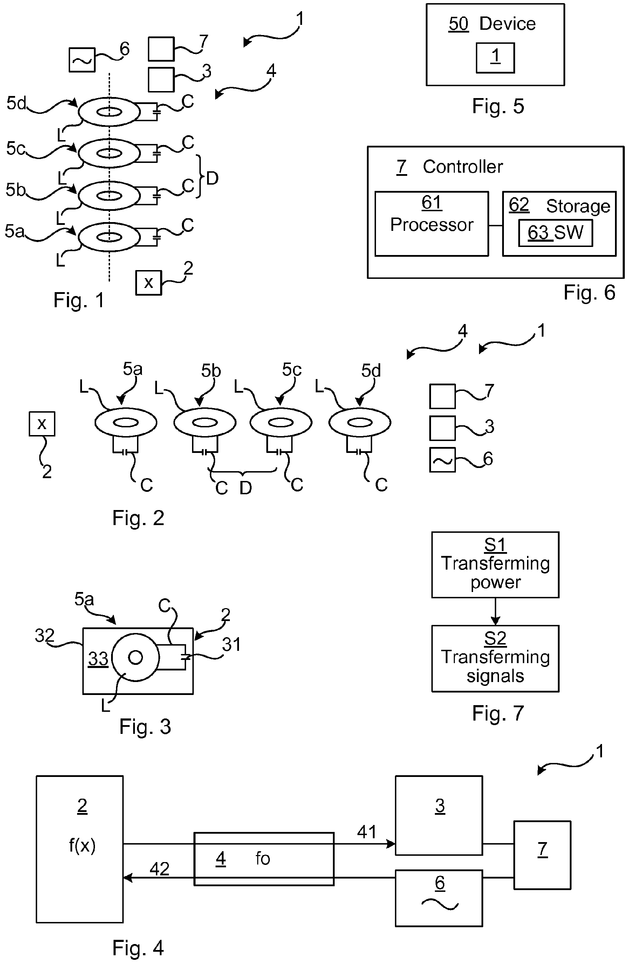

Figure 1 illustrates an embodiment of a sensor arrangement 1 comprising a 1D resonator array 4 of a plurality of substantially flat (planar) LC circuits 5 (typically analogue LCR circuits with a small resistance, R), here four LC circuits 5a, 5b, 5c and 5d, arranged co-axially stacked on-top of each other an axial distance D equidistantly from each other along an axis (indicated as a dotted line in figure 1) which is orthogonal to the respective planes of the planar LC circuits 5. Each LC circuit 5 comprises an inductive circuit L and a capacitive circuit C comprising at least one capacitor.

The resonator array 4 is arranged to wirelessly transfer power from an alternating current (AC) electrical power source 6 to at least one sensor 2, powering said sensor, which sensor 2 is configured to measure a property x, e.g. temperature and/or pressure, of an environment in an electrical device, e.g. a HV environment within said electrical device. Additionally, the resonator array 4 is arranged to wirelessly transfer sensor signals, typically including information about the measured property x, from the sensor 2 to a detector 3. The detector 3 may e.g. be or comprise an impedance meter, e.g. an impedance analyser.

The sensor arrangement 1 may also comprise a controller 7 for controlling the operation of the sensor arrangement 1 (see also figure 6).

Figure 2 illustrates another embodiment of a sensor arrangement 1. The sensor arrangement may be as discussed in relation to figure 1, but the resonator array is a 1D array of LC circuits 5 which are in a co-planar arrangement instead of a co-axial one. The substantially flat (planar) LC circuits 5 are arranged next to each other, substantially all in the same plane as the plane of each LC circuit.

In addition to the example embodiments of figures 1 and 2, it should be noted that the resonator array may follow a curved transfer path rather than a co-axial or co-planar path, as suitable for integrating the array in the electrical device and to power and signal transfers between the sensor 2 (e.g. at a high voltage) and the detector/power source at a more outer part (e.g. at a low or lower voltage) of the electrical device. It should also be noted that the resonator array may alternatively be a 2D or 3D array, though a 1D array may often be preferred. Further, it should be noted that the LC circuits may have any design and overall shape and need not be planar, though planar LC circuits may be preferred in some embodiments since they take up little space and may easily be printed on an electrically insulating substrate.

Figure 3 illustrates an embodiment of an LC circuit 5 of a resonator array 4. The LC circuit can be formed on or in, e.g. by printing, an electrically insulating material 33, e.g. a dielectric material 33, e.g. in the form of a film 32, e.g. a flexible film which may facilitate integration of the array 4 in crammed spaces of the electrical device.

According to the invention, the at least one sensor 2 is integrated with the resonator array 4, e.g. by being comprised in one of the LC circuits 5a of the array. The integrated sensor 2 may e.g. comprise a capacitor of the capacitive circuit C of the LC circuit 5a, e.g. the LC circuit furthest away from the detector 3. The capacitor of the integrated sensor may then comprise a material 31, e.g. a dielectric material, typically between its terminals, which is sensitive to the property x which it is arranged to sense. The material 31 may e.g. be or comprise a pyro-electric polymer or ceramic if the property is temperature or a piezo-electric polymer if the property is pressure. The capacitance of the capacitive circuit C is thus affected by the property x, giving a capacitance C(x) which may then be sensed and measured to give a measured value of x. The thickness of the film 32 may be at most of the order tens of microns (called thick film) and preferably in the order of sub-microns (thin film technology). The surface area (footprint) of the resonator 4 is expected to be in the range mm² to dm².

It is noted that a plurality of sensors 2 may be associated with the same array 4, in which case a plurality of sensors may be integrated with respective capacitive circuits C of the array 4 at different positions along the transfer path formed by the array.

Figure 4 illustrates the transfers within the sensor arrangement 1 during operation thereof. The resonator array 4 has a fixed natural frequency fₒ which is tuned to a natural frequency f of the sensor 2, which natural frequency f of the sensor is dependent on the property x of the environment. For instance, the fixed natural frequency fₒ of the resonator array 4 may be within the range of 10 kHz to 100 MHz. The fixed natural frequency fₒ is typically tuned to the sensor unit frequency f(x) at a certain reference point x=xₒ, whereby changes in the property x may propagate along the array 4 to be detected by the detector 3.

Thus, power 42 can be transferred from the electrical power source 6 to the sensor 2 via the array 4, and sensor signals 41 can be transferred from the sensor 2 to the detector 3 via the same array 4. There is thus no need for e.g. an antenna or galvanic contact with the sensor to obtain the signals 41 there from.

Figure 5 schematically illustrates that an embodiment of the sensor arrangement 1 can be comprised in an electrical device 1, e.g. a HV device.

Figure 6 illustrates a controller 7 of the sensor arrangement 1. The controller 7 comprises processing circuitry 61 e.g. a central processing unit (CPU). The processing circuitry 61 may comprise one or a plurality of processing units in the form of microprocessor(s). However, other suitable devices with computing capabilities could be comprised in the processing circuitry 61, e.g. an application specific integrated circuit (ASIC), a field programmable gate array (FPGA) or a complex programmable logic device (CPLD). The processing circuitry 61 is configured to run one or several computer program(s) or software (SW) 63 stored in a storage 62 of one or several storage unit(s) e.g. a memory. The storage unit is regarded as a computer program product as discussed herein, comprising computer-executable components of the SW 63 on a non-transitory computer readable medium, and may e.g. be in the form of a Random Access Memory (RAM), a Flash memory or other solid state memory, or a hard disk, or be a combination thereof. The processing circuitry 61 may also be configured to store data in the storage 62, as needed.

Embodiments of the present invention may be conveniently implemented using one or more conventional general purpose or specialized digital computer, computing device, machine, or microprocessor, including one or more processors 61, memory and/or computer readable storage media 62 programmed according to the teachings of the present disclosure. Appropriate software 63 coding can readily be prepared by skilled programmers based on the teachings of the present disclosure, as will be apparent to those skilled in the software art.

Figure 7 is a flow chart of an embodiment of a method of the present invention. The method is for detecting a measured property x in an electrical device environment. The method comprises, by means of a resonator array 4 comprising an array of LC circuits 5, wirelessly transferring S1 power 42 from an electrical power source 6 to a sensor 2 in the environment, powering said sensor. The method also comprises, by means of the resonator array 4, wirelessly transferring S2 signals 41 indicating a measurement of the property x from the sensor 2 to a detector 3.

The present disclosure has mainly been described above with reference to a few embodiments. However, as is readily appreciated by a person skilled in the art, other embodiments than the ones disclosed above are equally possible within the scope of the present disclosure, as defined by the appended claims.

## Claims

1. A sensor arrangement (1) comprising:
a sensor (2) configured to be arranged in a high-voltage, HV, environment and to measure a property of said environment;
a detector (3) configured to receive signals (41) from the sensor; and
a resonator array (4) comprising an array of LC circuits (5) arranged galvanically isolated from each other along a transfer path between the sensor and the detector and configured to wirelessly transfer power (42) to the sensor from an electrical power source (6) and to wirelessly transfer the sensor signals (41) from the sensor to the detector, and wherein the sensor (2) is integrated with the resonator array (4).

2. The sensor arrangement of claim 1, wherein the resonator array (4) has a fixed natural frequency (fₒ) which is tuned to a natural frequency (f) of the sensor (2) which is dependent on the property (x) of the environment, e.g. wherein the fixed natural frequency (fₒ) of the resonator array (4) is within the range of 10 kHz to 100 MHz.

3. The sensor arrangement of any preceding claim, wherein the detector (3) comprises an impedance meter, e.g. an impedance analyser.

4. The sensor arrangement of claim 1, wherein the integrated sensor (2) comprises a capacitor (C) of an LC circuit (5a) of the resonator array (4).

5. The sensor arrangement of claim 4, wherein the capacitor (C) comprises a dielectric material (31) which is sensitive to the property (x) of the environment, e.g. a pyro-electric polymer or ceramic if the property is temperature or a piezo-electric polymer if the property is pressure.

6. The sensor arrangement of any preceding claim, wherein each LC circuit (5) of the resonator array (4) is printed on an electrically insulating film (32), preferably of a dielectric material (33).

7. The sensor arrangement of any preceding claim, wherein the resonator array (4) comprises a plurality of flat LC circuits (5) co-axially arranged a predetermined distance (D) from each other.

8. The sensor arrangement of any preceding claim 1-6, wherein the resonator array (4) comprises a plurality of co-planar flat LC circuits (5) arranged side by side.

9. The sensor arrangement of any preceding claim, wherein the property (x) of the HV environment is any in the group of properties consisting of temperature, pressure, acceleration, moisture, acidity and oxygen level, preferably temperature or pressure, especially temperature.

10. An electrical device (50) comprising the communication arrangement (1) of any preceding claim.

11. The electrical device of claim 10, wherein the device (50) is a transformer.

12. A method of detecting a measured property (x) in a high-voltage, HV, environment, the method comprising:
by means of a resonator array (4) comprising an array of LC circuits (5) arranged galvanically isolated from each other along a transfer path between a sensor (2) and a detector (3), wirelessly transferring (S1) power (42) from an electrical power source (6) to the sensor (2), powering said sensor; and
by means of the resonator array (4), wirelessly transferring (S2) signals (41) indicating a measurement of the property (x) from the sensor (2) to the detector (3), and wherein the sensor (2) is integrated with the resonator array (4).

13. A computer program product (62) comprising computer-executable components (63) for causing a controller (7) to perform the method of claim 12 when the computer-executable components are run on processing circuitry (61) comprised in the controller.

## Patentansprüche

1. Sensoranordnung (1), die Folgendes umfasst:
einen Sensor (2), der dazu ausgelegt ist, in einer Hochspannungs- bzw. HV-Umgebung angeordnet zu werden und eine Eigenschaft der Umgebung zu messen;
einen Detektor (3), ausgelegt zum Empfangen von Signalen (41) von dem Sensor; und
ein Resonatorarray (4), umfassend ein Array von Schwingkreisen (5), die entlang eines Übertragungswegs zwischen dem Sensor und dem Detektor galvanisch voneinander getrennt angeordnet und dazu ausgelegt sind, Energie (42) drahtlos von einer elektrischen Energiequelle (6) zu dem Sensor zu übertragen und die Sensorsignale (41) von dem Sensor drahtlos zu dem Detektor zu übertragen, und wobei der Sensor (2) in dem Resonatorarray (4) integriert ist.

2. Sensoranordnung nach Anspruch 1, wobei das Resonatorarray (4) eine feste Eigenfrequenz (f₀) hat, die auf eine Eigenfrequenz (f) des Sensors (2) abgestimmt ist, die von der Eigenschaft (x) der Umgebung abhängt, wobei die feste Eigenfrequenz (f₀) des Resonatorarrays (4) z. B. im Bereich von 10 kHz bis 100 Mhz liegt.

3. Sensoranordnung nach einem der vorhergehenden Ansprüche, wobei der Detektor (3) ein Impedanzmessgerät, z. B. einen Impedanzanalysator, umfasst.

4. Sensoranordnung nach Anspruch 1, wobei der integrierte Sensor (2) einen Kondensator (C) eines Schwingkreises (5a) des Resonator-Arrays (4) umfasst.

5. Sensoranordnung nach Anspruch 4, wobei der Kondensator (C) ein dielektrisches Material (31) umfasst, das gegenüber der Eigenschaft (x) der Umgebung empfindlich ist, z. B. ein pyro-elektrisches Polymer oder Keramikmaterial, wenn es sich bei der Eigenschaft um die Temperatur handelt, oder ein piezoelektrisches Polymer, wenn es sich bei der Eigenschaft um den Druck handelt.

6. Sensoranordnung nach einem der vorhergehenden Ansprüche, wobei jeder Schwingkreis (5) des Resonatorarrays (4) auf einen elektrisch isolierenden Film (32), vorzugsweise aus einem dielektrischen Material (33), aufgedruckt ist.

7. Sensoranordnung nach einem der vorhergehenden Ansprüche, wobei das Resonatorarray (4) mehrere flache Schwingkreise (5) umfasst, die koaxial in einem vorbestimmten Abstand (D) zueinander angeordnet sind.

8. Sensoranordnung nach einem der vorhergehenden Ansprüche 1-6, wobei das Resonatorarray (4) mehrere komplanare flache Schwingkreise (5) umfasst, die nebeneinander angeordnet sind.

9. Sensoranordnung nach einem der vorhergehenden Ansprüche, wobei es sich bei der Eigenschaft (x) der HV-Umgebung um eine beliebige in der Gruppe von Eigenschaften bestehend aus Temperatur, Druck, Beschleunigung, Feuchtigkeit, Säure- und Sauerstoffgehalt, vorzugsweise Temperatur oder Druck, insbesondere Temperatur, handelt.

10. Elektrische Vorrichtung (50), die die Kommunikationsanordnung (1) nach einem der vorhergehenden Ansprüche umfasst.

11. Elektrische Vorrichtung nach Anspruch 10, wobei es sich bei der Vorrichtung (50) um einen Transformator handelt.

12. Verfahren zum Detektieren einer gemessenen Eigenschaft (x) in einer Hochspannungs- bzw. HV-Umgebung, wobei das Verfahren Folgendes umfasst:
mittels eines Resonatorarrays (4), umfassend ein Array von Schwingkreisen (5), die entlang eines Übertragungswegs zwischen einem Sensor (2) und einem Detektor (3) galvanisch voneinander getrennt angeordnet sind, drahtloses Übertragen (S1) von Energie (42) von einer elektrischen Energiequelle (6) zu dem Sensor (2), wodurch der Sensor gespeist wird; und
mittels des Resonatorarrays (4), drahtloses Übertragen (S2) von Signalen (41), die eine Messung der Eigenschaft (x) angeben, von dem Sensor (2) zu dem Detektor (3), und wobei der Sensor (2) in dem Resonatorarray (4) integriert ist.

13. Computerprogrammprodukt (62), umfassend computerausführbare Komponenten (63) zum Bewirken, dass eine Steuerung (7) das Verfahren nach Anspruch 12 durchführt, wenn die computerausführbaren Komponenten auf einer in der Steuerung enthaltenen Verarbeitungsschaltungsanordnung (61) ausgeführt werden.

## Revendications

1. Agencement de capteur (1) comprenant :
un capteur (2) configuré pour être agencé dans un environnement haute tension, HV, et pour mesurer une propriété dudit environnement ;
un détecteur (3) configuré pour recevoir des signaux (41) en provenance du capteur ; et
un ensemble de résonateurs (4) comprenant un ensemble de circuits LC (5) agencés de manière isolée galvaniquement les uns des autres le long d'un chemin de transfert entre le capteur et le détecteur et configurés pour transférer sans fil de la puissance (42) au capteur depuis une source de puissance électrique (6) et pour transférer sans fil les signaux (41) de capteur du capteur au détecteur, et le capteur (2) étant intégré à l'ensemble de résonateurs (4) .

2. Agencement de capteur selon la revendication 1, l'ensemble de résonateurs (4) ayant une fréquence naturelle fixe (f₀) accordée à une fréquence naturelle (f) du capteur (2) qui dépend de la propriété (x) de l'environnement, par ex. la fréquence naturelle fixe (f₀) de l'ensemble de résonateurs (4) étant dans la plage allant de 10 kHz à 100 MHz.

3. Agencement de capteur selon l'une quelconque des revendications précédentes, le détecteur (3) comprenant un impédancemètre, par ex. un analyseur d'impédance.

4. Agencement de capteur selon la revendication 1, le capteur (2) intégré comprenant un condensateur (C) d'un circuit LC (5a) de l'ensemble de résonateurs (4).

5. Agencement de capteur selon la revendication 4, le condensateur (C) comprenant un matériau diélectrique (31) sensible à la propriété (x) de l'environnement, par ex. un polymère ou une céramique pyroélectrique si la propriété est une température ou un polymère piézoélectrique si la propriété est une pression.

6. Agencement de capteur selon l'une quelconque des revendications précédentes, chaque circuit LC (5) de l'ensemble de résonateurs (4) étant imprimé sur un film isolant électriquement (32), de préférence d'un matériau diélectrique (33).

7. Agencement de capteur selon l'une quelconque des revendications précédentes, l'ensemble de résonateurs (4) comprenant une pluralité de circuits LC (5) plats agencés de manière coaxiale à une distance (D) prédéterminée les uns des autres.

8. Agencement de capteur selon l'une quelconque des revendications 1 à 6, l'ensemble de résonateurs (4) comprenant une pluralité de circuits LC (5) plats coplanaires agencés côte à côte.

9. Agencement de capteur selon l'une quelconque des revendications précédentes, la propriété (x) de l'environnement HV étant l'une quelconque dans le groupe consistant en une température, une pression, une accélération, une humidité, une acidité et un niveau d'oxygène, de préférence une température ou une pression, particulièrement une température.

10. Dispositif électrique (50) comprenant l'agencement de communication (1) selon l'une quelconque des revendications précédentes.

11. Dispositif électrique selon la revendication 10, le dispositif (50) étant un transformateur.

12. Procédé de détection d'une propriété (x) mesurée dans un environnement haute tension, HV, le procédé comprenant :
au moyen d'un ensemble de résonateurs (4) comprenant un ensemble de circuits LC (5) agencés de manière isolée galvaniquement les uns des autres le long d'un chemin de transfert entre un capteur (2) et un détecteur (3), le transfert sans fil (S1) de puissance (42) d'une source de puissance électrique (6) au capteur (2), alimentant ledit capteur ; et
au moyen de l'ensemble de résonateurs (4), le transfert sans fil (S2) de signaux (41) indiquant une mesure de la propriété (x) du capteur (2) au détecteur (3), et le capteur (2) étant intégré à l'ensemble de résonateurs (4) .

13. Produit programme informatique (62) comprenant des composants exécutables par ordinateur (63) pour amener un contrôleur (7) à réaliser le procédé selon la revendication 12 lorsque les composants exécutables par ordinateur sont exécutés sur des circuits de traitement (61) compris dans le contrôleur.
